# FASCICULE DE BREVET EUROPEEN

(11) **EP 3 776 640 B1**
(45) Date de publication et mention de la délivrance du brevet: **11.10.2023**
(21) Numéro de dépôt: 19715973.4
(22) Date de dépôt: 13.03.2019
(51) Int. Cl.: H01L 21/76, H01L 21/02, H01L 21/762

(54) **SUBSTRAT POUR APPLICATIONS RADIOFREQUENCES ET PROCEDE DE FABRICATION ASSOCIE**
SUBSTRAT FÜR RADIOFREQUENZANWENDUNGEN UND ZUGEHÖRIGES HERSTELLUNGSVERFAHREN
SUBSTRATE FOR RADIOFREQUENCY APPLICATIONS AND ASSOCIATED MANUFACTURING METHOD

(30) Priorité: 30.03.2018 FR 1852795
(43) Date de publication de la demande: 17.02.2021
(73) Titulaire: SOITEC, 38190 Bernin (FR)
(72) Inventeur: ALLIBERT, Frédéric, 38100 GRENOBLE (FR); VEYTIZOU, Christelle, 38190 BERNIN (FR); RADISSON, Damien, 38190 BRIGNOUD (FR)
(74) Mandataire: IP Trust
(86) Numéro de dépôt international: PCT/FR2019/050539
(87) Numéro de publication internationale: WO 2019/186010

(56) Documents cités:
- EP-A1- 3 109 893
- EP-A1- 3 203 495
- FR-A1- 2 990 561
- US-B1- 6 171 931

## Description

### DOMAINE DE L'INVENTION

La présente invention concerne le domaine des dispositifs radiofréquences intégrés. Elle concerne en particulier un substrat adapté pour lesdits dispositifs et un procédé de fabrication associé.

### ARRIERE PLAN TECHNOLOGIQUE DE L'INVENTION

Pour la plupart des applications impliquant la transmission ou la réception de signaux radiofréquences (10 MHz à 100 GHz), les dispositifs requièrent pour leur fabrication un substrat remplissant un cahier des charges de plus en plus exigeant, tiré en particulier par l'évolution des normes de la téléphonie mobile (2G, 3G, LTE, LTE Advanced, LTE Advanced PRO, 5G ...) . Les propriétés des matériaux du substrat doivent notamment garantir :
- de faibles pertes d'insertion (faible atténuation du signal) et une bonne linéarité (faible distorsion du signal à l'origine d'harmoniques), typiquement en présentant une résistivité effective, sur une large gamme de fréquences, supérieure à 1000 ohms.cm ;
- une stabilité de ces performances en température, en particulier dans la gamme d'utilisation des dispositifs [-40°C ; 150°C] ;
- un faible couplage capacitif entre la couche active et le substrat support, typiquement grâce à une permittivité diélectrique égale ou inférieure à celle du silicium (*ε_{silicium}* = 11).

Par ailleurs, pour répondre à des besoins en forts volumes, le substrat doit être compatible avec l'industrie du semi-conducteur, et en particulier avec les lignes de fabrication CMOS silicium. Bien sur, il doit en plus présenter un coût compétitif pour être adopté par les applications grand public, en particulier dans le domaine des télécommunications (téléphonie et réseau cellulaire, connectivité Wi-Fi, Bluetooth) .

Les dispositifs radiofréquences (RF), tels que des commutateurs et adaptateurs d'antenne, des amplificateurs de puissance, des amplificateurs faible bruit ou encore des composants passifs (R, L, C) peuvent être élaborés sur différents types de substrats.

On connaît par exemple les substrats silicium sur saphir, communément appelés SOS (pour « silicon on sapphire » selon l'appellation anglo-saxonne), qui font bénéficier les composants élaborés selon des technologies micro-électroniques dans la couche superficielle de silicium, des propriétés isolantes du substrat en saphir, indépendantes de la température, de sa conductivité thermique supérieure à 20 W/m.K et de sa permittivité inférieure à 11. Par exemple, les commutateurs d'antenne et amplificateurs de puissance fabriqués sur ce type de substrat présentent de très bons facteurs de mérite mais sont principalement utilisés pour des applications de niche du fait du coût global trop élevé de la solution.

On connaît également les substrats à base de silicium haute résistivité comprenant un substrat support, une couche de piégeage (de quelques centaines de nanomètres à quelques microns d'épaisseur) disposée sur le substrat support, une couche diélectrique disposée sur la couche de piégeage, et une couche de semi-conducteur disposée sur la couche diélectrique. Le substrat support présente habituellement une résistivité supérieure à 1 kOhm.cm. La couche de piégeage peut comprendre du silicium poly-cristallin non dopé. La combinaison d'un substrat support en silicium haute résistivité et d'une couche de piégeage selon l'état de l'art permet d'éliminer la couche de conduction parasite présente habituellement sous la couche d'oxyde enterré dans les substrats SOI HR (silicium sur isolant avec substrat support en silicium haute résistivité). L'homme du métier trouvera une revue des performances des dispositifs RF fabriqués sur un substrat semi-conducteur haute résistivité connu de l'état de la technique dans « Silicon-on-insulator (SOI) Technology, manufacture and applications », points 10.7 et 10.8, Oleg Kononchuk et Bich-Yen Nguyen, chez Woodhead Publishing.

Néanmoins, une couche de piégeage en poly-silicium présente l'inconvénient de subir une recristallisation partielle lors des étapes de traitements thermiques à hautes températures, ce qui contribue à diminuer la densité de pièges dans la couche. La dégradation de la performance du dispositif RF liée à cette diminution de densité de pièges peut être rédhibitoire pour certaines applications. Par ailleurs, ces substrats peinent à garantir la stabilité des performances RF sur toute la gamme de températures d'utilisation, notamment au-delà de 100°C : leur résistivité chute compte tenu de la génération de porteurs thermiques dans le substrat support et le couplage dispositif/substrat redevient un contributeur majeur d'atténuation et de distorsion du signal.

Pour améliorer les performances de ces substrats, il pourrait être envisagé d'augmenter l'épaisseur de la couche de piégeage (au-delà de plusieurs microns), pour augmenter la quantité de pièges disponibles et pour éloigner le substrat support des dispositifs, limitant ainsi l'impact des porteurs thermiques générés dans le substrat support. Cette option présente néanmoins l'inconvénient d'augmenter la contrainte et la déformation (« bow » selon la terminologie anglosaxonne) des substrats, qui deviennent difficiles voire impossibles à traiter dans les équipements standard microélectroniques.

D'autres substrats supports, tels que le nitrure d'aluminium ou le carbure de silicium, rempliraient le cahier des charges des propriétés RF mais ils ne sont pas directement compatibles avec l'industrie du semi-conducteur standard. Le document EP3203495 propose un substrat support comprenant un corps fritté, par exemple en nitrure d'aluminium ou en nitrure de silicium, recouvert d'un film amorphe pour prévenir la contamination métallique dans une couche utile en silicium, collée et transférée sur ledit substrat support.

L'utilisation de tels substrats en tant que substrat support pour un report de la couche finale de dispositifs est envisageable ; néanmoins, le coût de ces matériaux spécifiques combiné à celui des technologies de transfert de circuit reste encore trop élevé pour une adoption massive de ces solutions.

### OBJET DE L'INVENTION

Un objet de l'invention est donc de proposer un substrat adapté pour les applications radiofréquences, remédiant à tout ou partie des inconvénients de l'art antérieur.

### BREVE DESCRIPTION DE L'INVENTION

L'invention concerne un substrat pour des dispositifs microélectroniques radiofréquences comprenant :
- un substrat support en un matériau semi-conducteur,
- une couche intermédiaire,
- une couche utile disposée sur la couche intermédiaire.

Le substrat comprend une couche composite frittée, disposée sur le substrat support et formée à partir d'un mélange de poudres d'au moins un premier matériau diélectrique et un deuxième matériau diélectrique différent du premier ; la nature du premier matériau, la nature du deuxième matériau et la proportion desdits matériaux dans le mélange de poudres sont choisies pour conférer à la couche composite frittée un coefficient de dilatation thermique apparié avec celui du substrat support, à plus ou moins 30% ; ladite couche composite frittée présente une épaisseur comprise entre 5 microns et 100 microns ; la couche intermédiaire est disposée sur la couche composite frittée.

Selon des caractéristiques avantageuses de l'invention, prises seules ou en combinaison :
- la couche composite frittée présente une épaisseur comprise entre 10 microns et 100 microns ;
- le coefficient de dilatation thermique de la couche composite frittée est apparié avec celui du substrat support, à plus ou moins 10%, voire à plus ou moins 5% ;
- le substrat support présente une résistivité supérieure à 500 ohm.cm ;
- le substrat support est en silicium ;
- les premier et deuxième matériaux diélectriques sont choisis parmi l'oxyde de silicium, le nitrure de silicium, le nitrure d'aluminium, l'alumine, la mullite ;
- le substrat comprend une couche de protection disposée entre le substrat support et la couche composite frittée
- la couche intermédiaire est une couche diélectrique formée d'un matériau choisi parmi un oxyde de silicium, un nitrure de silicium, un oxynitrure de silicium, un nitrure d'aluminium ;
- la couche utile est composée d'un matériau choisi parmi les matériaux semi-conducteurs, isolants ou conducteur, ou encore les matériaux piézoélectriques.

L'invention concerne également une structure de dispositifs microélectroniques radiofréquences comprenant :
- un substrat tel que ci-dessus ;
- une couche de dispositifs microélectroniques, disposée sur ledit substrat.

Selon des modes avantageux, le dispositif microélectronique est un commutateur ou adaptateur d'antenne ou un amplificateur de puissance ou un amplificateur faible bruit ou un composant passif ou autre circuit fonctionnant à haute fréquence ou un composant MEMS radiofréquence ou encore un filtre radiofréquence.

L'invention concerne enfin un procédé de fabrication d'un substrat pour des dispositifs microélectroniques radiofréquences, comprenant les étapes suivantes :
a) La fourniture d'un substrat support en un matériau semi-conducteur, présentant une première face ;
b) Le dépôt d'une couche formée d'un mélange de poudres d'au moins un premier matériau diélectrique et un deuxième matériau diélectrique différent du premier, sur la première face du substrat support ;
c) Le frittage de la couche formée du mélange de poudres pour obtenir une couche composite frittée solidaire de la première face du substrat support et présentant une épaisseur comprise entre 5 microns et 100 microns ; le premier matériau, le deuxième matériau et la proportion desdits matériaux dans le mélange de poudres étant choisis pour conférer à la couche composite frittée un coefficient de dilatation thermique apparié avec celui du substrat support, à plus ou moins 30%
d) L'assemblage d'une couche utile et du substrat support de manière à disposer la couche composite frittée entre la couche utile et le substrat support, une couche intermédiaire étant disposée entre la couche utile et la couche composite frittée.

Selon des caractéristiques avantageuses de l'invention, prises seules ou en combinaison :
- la première face du substrat support comporte une couche de protection, préalablement au dépôt de la couche formée du mélange de poudres de l'étape b) ;
- la couche de protection est formée par au moins un matériau choisi parmi le nitrure de silicium, l'oxynitrure de silicium, l'oxyde de silicium ;
- le mélange de poudres se présente sous la forme d'une pâte visqueuse, et le dépôt de la couche formée par ledit mélange à l'étape b) est réalisé par enduction centrifuge ;
- le dépôt de la couche formée par le mélange de poudres est suivi d'un traitement thermique à basse température, pour évacuer au moins un composant liquide de la pâte visqueuse ;
- la couche utile fournie pour l'étape d) d'assemblage est un substrat donneur composé d'un matériau choisi parmi les matériaux semi-conducteurs, isolants ou conducteur, ou encore les matériaux piézoélectriques ;
- le procédé comprend une étape e) d'amincissement du substrat donneur jusqu'à l'épaisseur souhaitée de la couche utile pour la fabrication des dispositifs microélectroniques radiofréquences.

### BREVE DESCRIPTION DES DESSINS

D'autres caractéristiques et avantages de l'invention ressortiront de la description détaillée de l'invention qui va suivre en référence aux figures annexées sur lesquelles :
- la figure 1a présente un substrat conforme à l'invention ;
- le tableau 1 présente des propriétés de matériaux susceptibles de composer la couche composite frittée d'un substrat conforme à l'invention ;
- la figure 1b présente un graphe montrant la température à laquelle la courbure (bow) d'un substrat (en silicium, d'épaisseur 750 microns) atteint 150 microns, en fonction du coefficient de dilatation thermique de la couche composite (d'épaisseur 5 microns) disposée sur ce substrat et pour différents module d'Young de ladite couche composite ;
- les figures 2a, 2b, 3a et 3b présentent tout ou partie de substrats conformes à l'invention ;
- la figure 4 présente une structure de dispositifs microélectroniques radiofréquences conforme à l'invention ;
- les figures 5a à 5e présentent un procédé de fabrication d'un substrat conforme à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

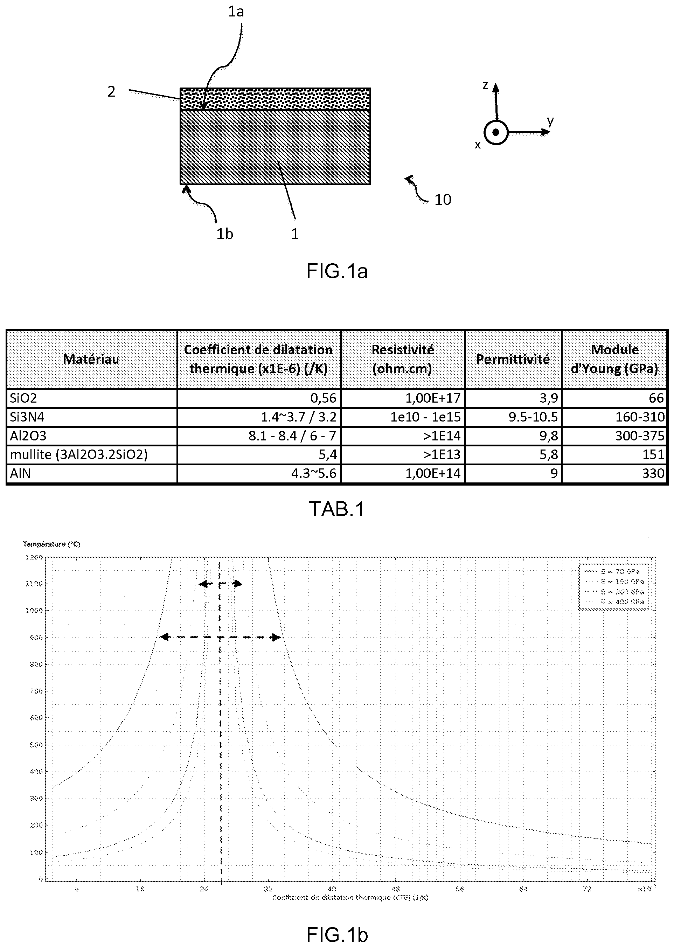

L'invention concerne un substrat 10 adapté pour la fabrication de dispositifs microélectroniques radiofréquences, comprenant un substrat support 1 en un matériau semi-conducteur (figure 1a). Avantageusement, le substrat support 1 est formé en silicium monocristallin.

Le substrat 10 selon l'invention comprend également une couche composite frittée 2, disposée sur le substrat support 1 et formée à partir de poudres d'au moins deux matériaux diélectriques différents (figure 1a). Par couche frittée, on entend une couche issue de la consolidation d'un mélange de poudres : cette consolidation est obtenue par apport d'énergie thermique et optionnellement mécanique, mais sans fusion d'au moins un des matériaux pulvérulents du mélange. Le caractère fritté de la couche composite peut donc être détecté par analyse structurale de ladite couche (par exemple par microscopie électronique à balayage). Les particules ou grains des poudres de matériaux apparaissent soudés entre eux et la densité de la couche composite dépend du niveau de compactage du mélange lors de l'apport d'énergie pour la consolidation.

Les particules formant la poudre de chacun des matériaux de la couche composite frittée 2 présentent des dimensions suivant une distribution typiquement gaussienne. Dans la suite de la description, la taille moyenne des particules sera assimilée au diamètre équivalent moyen des particules d'un matériau donné. La taille moyenne des particules peut varier entre environ 1 micron et 10 microns.

Préférentiellement, les au moins deux matériaux diélectriques composant la couche composite frittée 2 (appelés premier et deuxième matériaux) sont choisis parmi l'oxyde de silicium, le nitrure de silicium, le nitrure d'aluminium, l'alumine, la mullite (tableau 1), notamment du fait de la haute résistivité de ces matériaux et de leur compatibilité avec des traitements à hautes températures.

La couche composite frittée 2 pourra éventuellement comprendre trois matériaux différents ou plus.

La couche composite frittée 2 présente en outre une épaisseur supérieure à 5 microns, voire supérieure à 10 microns. L'épaisseur de la couche composite frittée 2 est choisie en fonction du type de dispositifs microélectroniques radiofréquences destinés à être élaborés sur le substrat 10.

En général, elle présentera une épaisseur comprise entre 10 microns et 100 microns pour empêcher ou au moins limiter la pénétration du champ électromagnétique généré par les dispositifs RF dans le substrat support 1 : ainsi, on limite également l'interaction de ce champ électromagnétique avec les porteurs libres (par exemple porteurs thermiques) susceptibles d'apparaître dans le substrat support 1.

Pour limiter la pénétration du champ électromagnétique, les premier et deuxième matériaux pourront préférentiellement être choisis pour abaisser au mieux la permittivité équivalente de la couche composite frittée 2. Une permittivité faible (typiquement inférieure à 11, la permittivité du silicium) autorisera la mise en oeuvre d'épaisseurs de couche composite 2 plus faibles.

Si la pénétration du champ électromagnétique est confinée dans la couche composite frittée 2, le substrat support 1 pourra présenter une résistivité standard (typiquement quelques dizaines d'ohms.cm). Si le champ électromagnétique est susceptible de pénétrer de manière plus ou moins importante dans le substrat support 1, la résistivité dudit substrat support 1 sera avantageusement choisie supérieure à 500 ohm.cm, voire supérieure à 1 kohm.cm.

La couche composite frittée 2 présente également un coefficient de dilatation thermique (CTE) apparié avec celui du substrat support 1. Le coefficient de dilatation thermique de la couche composite 2 est défini par la moyenne des coefficients de dilatation thermique des matériaux composant ladite couche 2, pondérée par leur fraction volumique dans la couche composite 2. Par « apparié avec le coefficient de dilatation thermique du substrat support 1 », on entend au plus proche dudit coefficient de dilatation thermique. Selon l'invention le CTE de la couche composite frittée 2 est à plus ou moins 30% de la valeur du CTE du substrat support 1. Avantageusement, il est à plus ou moins 10% de la valeur du CTE du substrat support 1, voire à plus ou moins 5%, voire encore plus proche à plus ou moins 3% ou plus ou moins 1%.

A titre d'exemple, une couche composite frittée 2 formée à partir de poudres d'oxyde de silicium (SiO2) et d'alumine (Al2O3), dans les proportions 1 volume de Al2O3 et 2,7 volumes de SiO2, présente un coefficient de dilation thermique (CTE 2,67^{E}-6/°K) apparié au coefficient de dilatation thermique d'un substrat support 1 en silicium (2,6^{E}-6 /°K), soit dans ce cas, présentant un écart inférieur à 3%.

Avantageusement, le CTE de la couche composite 2 est choisi de manière à ce que le substrat 10, muni de la couche composite 2 d'une épaisseur supérieure à 5 microns, n'excède pas une courbure (bow) supérieure à environ 150 microns au cours des procédés micro-électroniques d'élaboration des couches composant le substrat 10 et des composants dans et sur le substrat 10. Rappelons que lesdits procédés micro-électroniques pourront notamment comprendre des traitements thermiques à des températures élevées, allant de 900°C à 1150°C par exemple.

A titre d'illustration, le graphe de la figure 1b montre la température à laquelle la courbure (bow) d'un substrat 10 (le substrat support 1 étant en silicium, d'épaisseur 750 microns et de diamètre 300mm) atteint 150 microns, en fonction du coefficient de dilatation thermique de la couche composite 2 (d'épaisseur 5 microns) disposée sur ce substrat et pour différents modules d'Young de ladite couche composite 2.

Par exemple, pour une température maximale de traitement de 900°C, si la couche composite 2 présente un module d'Young équivalent (défini comme la moyenne des modules d'Young des matériaux composant ladite couche 2, pondérée par leur fraction volumique) de l'ordre de 70GPa, le CTE de la couche composite 2 doit être au maximum à +/- 30% de la valeur du CTE du substrat support 1, pour rester en deçà de la courbe en trait plein (c'est-à-dire pour maintenir la courbure (bow) du substrat 10 en-dessous de 150 microns).

Selon un autre exemple, pour une température maximale de traitement de 1100°C, si la couche composite 2 présente un module d'Young équivalent de l'ordre de 150GPa, le CTE de la couche composite 2 doit être au maximum à +/- 11% de la valeur du CTE du substrat support 1, pour rester en deçà de la courbe en trait pointillé correspondant à « E=150GPa » (c'est-à-dire pour maintenir la courbure (bow) du substrat 10 en-dessous de 150 microns).

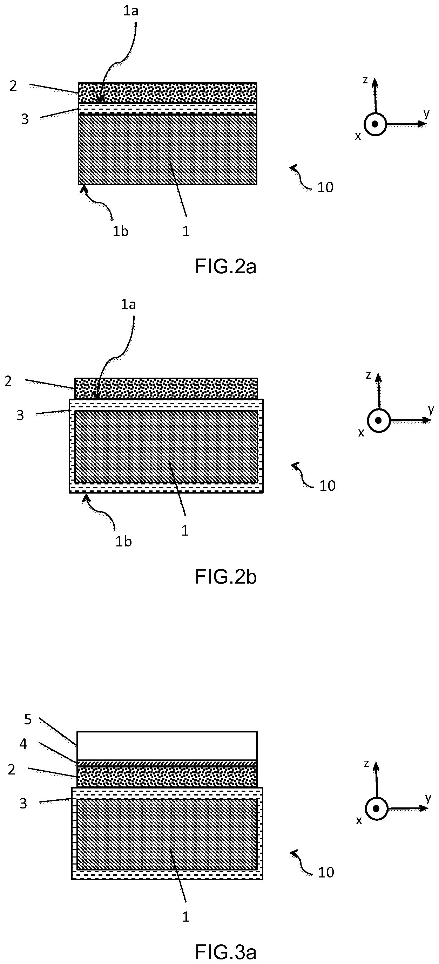

Selon une variante, le substrat 10 peut comprendre une couche de protection 3 disposée entre le substrat support 1 et la couche composite frittée 2. Comme illustré sur les figures 2a et 2b, le substrat 10 comprend dans ce cas une couche de protection 3 disposée sur sa première face 1a, et potentiellement sur la deuxième face 1b et sur les tranches dudit substrat support 1 (figure 2b). Comme nous le verrons lors de la description du procédé de fabrication du substrat 10, la couche de protection 3 permet d'éviter ou au moins de limiter la diffusion d'impuretés contenues dans la couche composite frittée 2 ou présentes lors de l'élaboration de ladite couche 2, dans le substrat support 1.

Pour la fabrication de dispositifs microélectroniques sur le substrat 10, une couche utile 5 est habituellement requise ; elle est nommée « utile » car les dispositifs seront ultérieurement élaborés dans ou sur cette couche 5.

Le substrat 10 selon l'invention comprend une couche utile 5 disposée sur la couche composite frittée 2. La couche utile 5 pourra être composée d'un matériau choisi parmi les matériaux semi-conducteurs (dont le silicium, le silicium-germanium, le germanium, le carbure de silicium, etc), isolants ou conducteur, ou encore les matériaux piézoélectriques (dont le niobate de lithium, le tantalate de lithium, etc).

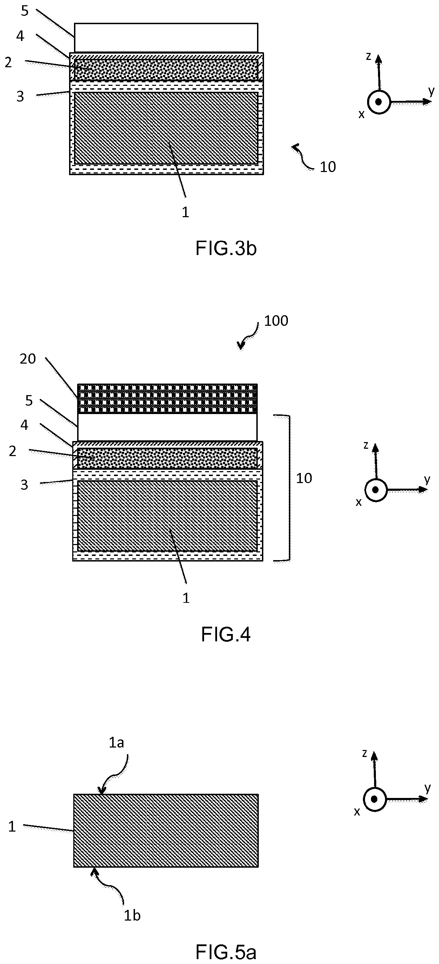

Le substrat 10 comprend une couche intermédiaire 4 disposée sur la couche composite frittée 2 (figure 3a), pouvant facultativement encapsuler complètement ladite couche composite (figure 3b). La couche intermédiaire 4 pourra être une couche diélectrique formée d'un matériau choisi parmi un oxyde de silicium, un nitrure de silicium, un oxynitrure de silicium, un nitrure d'aluminium, etc.

La couche utile 5 est alors disposée sur la couche intermédiaire 4. La couche intermédiaire 4 peut présenter notamment une fonction d'isolation électrique entre la couche utile 5 et la couche composite 2, et/ou une fonction de barrière de diffusion évitant la contamination de la couche utile 5 par des impuretés présentes dans la couche composite frittée 2.

Le substrat 10 selon l'invention comporte une couche composite frittée 2 présentant les propriétés d'un diélectrique et un coefficient de dilatation thermique apparié à celui du substrat support 1 sous-jacent. L'épaisseur de la couche composite 2 peut être choisie en fonction des dispositifs microélectroniques RF destinés à être élaborés sur le substrat 10, de manière à éviter (ou à limiter fortement) la pénétration d'ondes électromagnétiques dans le substrat support 1. Le coefficient de dilatation thermique de la couche composite 2 étant apparié avec celui du substrat support 1, l'épaisseur de la couche composite frittée 2 n'a pas besoin d'être limitée pour des raisons de contraintes et de déformations (bow) induites dans le substrat 10.

Comme précédemment énoncé, le coefficient de dilatation thermique peut être choisi de sorte que, lors des traitements thermiques appliqués au substrat 10 pour l'élaboration de la couche utile 5 ou des dispositifs microélectroniques 20 (typiquement entre 900° et 1150°C), l'amplitude de la courbure dudit substrat soit maintenue inférieure à un seuil compatible avec des étapes et équipements microélectroniques standards ; en particulier, on visera une courbure (bow) inférieure à 150 microns pour un substrat de 300mm de diamètre.

La couche composite frittée 2 du fait de son caractère diélectrique et de son épaisseur adaptée, confère ainsi au substrat 10 les propriétés requises pour garantir :
- de faibles pertes d'insertion (faible atténuation du signal) et une bonne linéarité (faible distorsion du signal à l'origine d'harmoniques) ;
- une stabilité de ses performances en température, en particulier dans la gamme d'utilisation des dispositifs [-40°C ; 150°C] ;
- un faible couplage capacitif entre la couche utile et le substrat support, typiquement grâce à une permittivité diélectrique égale ou inférieure à celle du silicium (*ε_{silicium}* = 11).

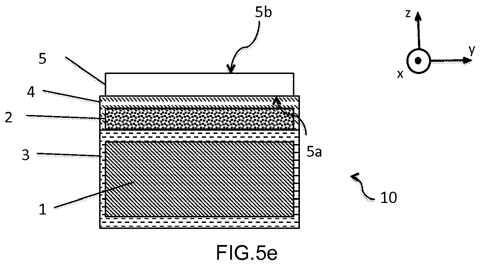

L'invention concerne également un procédé de fabrication d'un substrat 10 adapté pour des dispositifs microélectroniques radiofréquences, présenté sur les figures 5a à 5e.

Le procédé comprend en premier lieu une étape a) de fourniture d'un substrat support 1 en un matériau semi-conducteur. Le substrat support 1 présente une face avant, dite première face 1a et une face arrière, dite deuxième face 1b (figure 5a).

Le procédé comporte ensuite une étape b) comprenant le dépôt d'une couche 2' formée d'un mélange de poudres d'au moins un premier matériau diélectrique et un deuxième matériau diélectrique différent du premier, sur la première face 1a du substrat support 1.

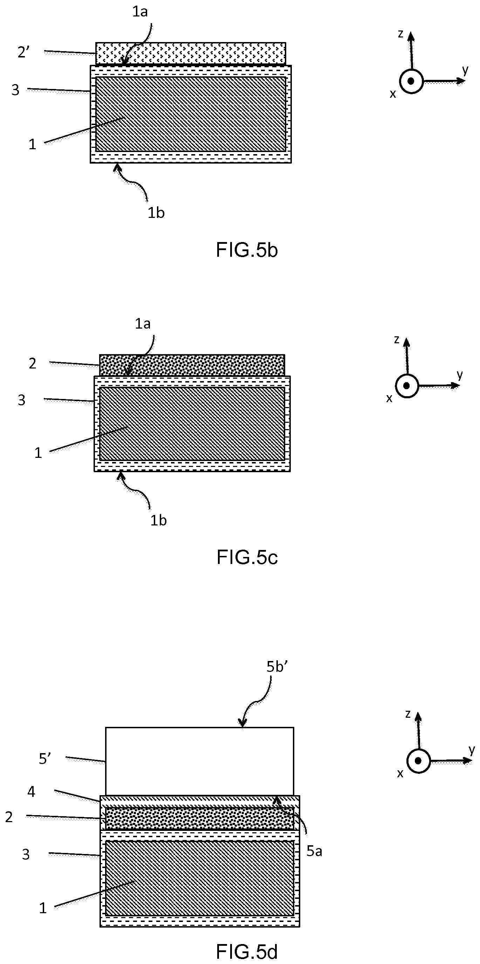

Optionnellement, la première face 1a du substrat support 1 comporte une couche de protection 3 élaborée préalablement au dépôt de la couche 2' de mélange de poudres ; la couche de protection 3 peut, comme illustré sur la figure 5b, encapsuler complètement le substrat support 1, c'est-à-dire recouvrir sa face arrière 1b et sa tranche. La couche de protection 3 est formée par au moins un matériau choisi parmi le nitrure de silicium, un oxynitrure de silicium et un oxyde de silicium, et peut être élaborée par différentes techniques connues de dépôt chimique. Elle permet d'éviter ou au moins de limiter la diffusion d'impuretés contenues dans la couche 2', dans le substrat support 1.

Selon une première variante de mise en oeuvre, le mélange de poudres se présente sous la forme d'une pâte visqueuse.

Une telle pâte est habituellement obtenue en ajoutant un composé liquide, de type solvant (notamment alcool, par exemple l'éthanol), au mélange sec de poudres. Typiquement, les poudres utilisées contiennent des particules dont la taille moyenne est comprise entre environ 1 et 10 microns. Pour former des couches composites 2 de 5 à 10 microns d'épaisseur, les plus petites tailles de particules seront préférées.

Alternativement, le mélange de poudres peut être intégré à une matrice de type polymère à base de silicium (PDC pour polymer-derived ceramics), apte à se transformer en céramique à haute température. Notons que dans le cas d'une couche 2' avec matrice en PDC, la couche composite frittée 2 qui sera obtenue ultérieurement comprendra le premier et le deuxième matériau diélectrique venant du mélange de poudres, mais également du silicium venant de la transformation en céramique de la matrice. Avantageusement, on visera d'avoir moins de 30% de silicium dans la couche composite 2. Les interstices étant localisés et non continus dans la couche composite 2, la présence de silicium dans lesdits interstices n'affecte pas le caractère diélectrique de la couche composite 2.

Le dépôt de la couche 2' formée par ledit mélange à l'étape b) est préférentiellement réalisé par enduction centrifuge (« spin coating » ou « dip coating » selon la terminologie anglosaxonne) ou sérigraphie à travers un masque.

La viscosité de la pâte est ajustée par le rapport poudres / composé liquide (solvant et/ou polymère). Elle est choisie pour permettre un dépôt uniforme de la couche 2', à des épaisseurs supérieures à 5 microns, voire supérieures à 10 microns, jusqu'à environ 100 microns.

Le dépôt de la couche 2' est suivi d'un traitement thermique à basses températures (par exemple entre 150°C et 400°C) permettant d'évacuer le ou les solvant(s) de la couche 2' et éviter tout dégazage ultérieurement dans le procédé, notamment après l'étape d'assemblage (décrite plus loin).

Selon une deuxième variante de mise en oeuvre, le mélange de poudres se présente sous une forme sèche pulvérulente et est déposé en une couche 2' sur la première face 1a du substrat support 1. La mise en forme de cette couche 2' peut être réalisée par moulage par compression ou compression isostatique à chaud. Dans les deux cas, une contrainte en compression est appliquée à la couche 2' pour rendre solidaires entre elles et avec la première face 1a, les particules des poudres du mélange. Un outillage spécifique est nécessaire pour maintenir le mélange pulvérulent sur le substrat et appliquer une contrainte en compression uniforme sur toute la surface dudit substrat 1.

Le procédé de fabrication selon l'invention comporte une étape c) comprenant le frittage de la couche 2' formée du mélange de poudres, pour obtenir une couche composite frittée 2 solidaire de la première face 1a du substrat support 1 (figure 5c).

Le frittage s'opère habituellement à hautes températures, typiquement supérieures à 1000°C, pendant une durée pouvant aller de quelques heures à environ 24 heures. La température de frittage reste néanmoins inférieure à la température de fusion d'au moins une des poudres contenues dans la couche 2'. Sous l'effet de la chaleur, les particules des poudres se soudent entre elles, ce qui forme la cohésion de la couche composite 2 résultante. La couche composite 2 se solidarise également avec la première face 1a du substrat support 1.

Optionnellement, le frittage peut en plus être effectué sous contrainte mécanique, ce qui permet de compacter davantage la couche composite 2.

La couche composite frittée 2 est ainsi composée de particules du premier et du deuxième matériau diélectrique. Entre les particules, selon le niveau de compactage, il peut exister plus ou moins d'interstices vides (ou contenant la céramique issue d'une matrice PDC). Selon la distribution en taille des particules, la fraction volumique de ces interstices pourra atteindre environ 50%, et sera préférentiellement maintenue inférieure à 25%, voire inférieure à 15%, pour conférer une bonne tenue mécanique à la couche composite 2. Notons que les interstices participent à l'augmentation de la densité de pièges (pour les charges électriques mobiles), ce qui peut être favorable pour maintenir les propriétés de haute résistivité du substrat (couche de piégeage).

L'épaisseur de la couche 2' déposée à l'étape b) est choisie de manière à obtenir l'épaisseur souhaitée de couche composite frittée 2. En effet, selon le type de couche déposée 2' (sous forme de pâte avec solvant et/ou polymère ou sous forme sèche), la réduction d'épaisseur lors de l'étape de frittage sera plus ou moins importante. Une réduction en volume de la couche 2' de l'ordre de 10 à 30% peut s'opérer selon les cas.

A l'issue de l'étape de frittage, la couche composite frittée 2 selon l'invention doit présenter une épaisseur supérieure à 5 microns.

De plus, selon la présente invention, la nature du premier matériau, la nature du deuxième matériau et la proportion desdits matériaux dans le mélange de poudres est choisis pour conférer à la couche composite frittée 2 un coefficient de dilatation thermique apparié avec celui du substrat support 2, à mieux que plus ou moins 30%.

Avantageusement, comme illustré sur la figure 4c la première face 1a du substrat support 1 comporte une couche de protection 3, préalablement au dépôt de la couche formée du mélange de poudres de l'étape b). La couche de protection 3 est formée par au moins un matériau choisi parmi le nitrure de silicium, l'oxynitrure de silicium, l'oxyde de silicium.

Le procédé de fabrication comprend en outre, après l'étape c), une étape d) d'assemblage d'une couche utile 5 et du substrat support 1 de manière à disposer la couche composite frittée 2 entre la couche utile 5 et le substrat support 1. La couche utile 5 pourra être composée d'un matériau choisi parmi les matériaux semi-conducteurs, isolants ou conducteur, ou encore les matériaux piézoélectriques. Elle pourra par exemple être en silicium, en silicium germanium, en germanium, en matériau III-V, en niobate de lithium, en tantalate de lithium, en nitrure d'aluminium, en PZT, etc.

Une couche intermédiaire 4 est déposée sur la couche composite 3, préalablement à l'étape d) d'assemblage. A titre d'exemple, son épaisseur pourra varier entre quelques nanomètres et quelques microns. Avantageusement, la couche intermédiaire 4 est formée d'un matériau choisi parmi l'oxyde de silicium, le nitrure de silicium, un oxynitrure de silicium ou le nitrure d'aluminium. Elle pourra être déposée par différentes techniques connues de dépôt chimique.

Cette couche intermédiaire 4 procure d'une part, une encapsulation de la couche composite frittée 2, évitant ou au moins limitant les risques de contamination entre les différentes couches du substrat 10 selon l'invention ; d'autre part, la couche intermédiaire 4 peut être avantageuse en vue de l'assemblage avec la couche utile 5, pour permettre une préparation de surface classique de ladite couche intermédiaire 4, et non une préparation spécifique à la composition de la couche composite frittée 3.

Avantageusement, l'étape d'assemblage est réalisée par collage direct, par adhésion moléculaire des deux surfaces mises en contact : c'est-à-dire de la première face 5a de la couche utile 5 et de la face libre de la couche composite 2. Le principe de l'adhésion moléculaire, bien connu dans l'état de l'art ne sera pas décrit plus en détail ici.

De manière alternative, l'assemblage pourra être réalisé par ajout d'une couche de matière adhésive, ou par toute autre technique de collage adaptée à l'application visée.

Pour la plupart des procédés d'assemblage, un bon état de surface (propreté, faible rugosité, ...) des substrats à assembler sera requis.

Selon une variante, la couche utile 5 fournie pour l'étape d) d'assemblage est un substrat donneur 5' composé d'un matériau choisi parmi les matériaux semi-conducteurs, isolants ou conducteur, ou encore les matériaux piézoélectriques (figure 5d) .

Le procédé de fabrication comprend alors une étape e) d'amincissement du substrat donneur 5', au niveau de sa face arrière 5b', jusqu'à l'épaisseur souhaitée de la couche utile 5 pour la fabrication des dispositifs microélectroniques radiofréquences.

A titre d'exemple, l'étape e) d'amincissement peut être basée sur des procédés de transfert de couches minces connus de l'homme du métier, parmi lesquels :
- le procédé Smart Cut^{™}, basé sur une implantation d'ions légers d'hydrogène et/ou d'hélium dans un substrat donneur (avant l'étape d'assemblage) ; une étape de détachement (après l'étape d'assemblage) permet ensuite de séparer une couche mince superficielle (la couche utile) du substrat donneur, au niveau du plan de fragilisation défini par la profondeur d'implantation des ions. Des étapes de finition, pouvant inclure des traitements thermiques à haute température, confèrent enfin la qualité cristalline et de surface requise à la couche utile 40. Ce procédé est particulièrement adapté pour la fabrication de couches utiles très minces, d'épaisseur comprise entre quelques nanomètres et environ 1,5µm par exemple pour les couches de silicium.
- le procédé Smart Cut suivi d'une étape d'épitaxie, permettant notamment d'obtenir des couches utiles plus épaisses, par exemple de quelques dizaines de nm à 20µm.
- les procédés d'amincissement mécanique, chimique et/ou mécano-chimique ; ils consistent à amincir le substrat donneur au niveau de sa face arrière, jusqu'à l'épaisseur souhaitée de couche utile, par exemple par rodage (« grinding » selon la terminologie anglo-saxonne) et par polissage (CMP pour « chemical mechanical polishing »). Ces procédés sont particulièrement adaptés au report de couches dites épaisses, par exemple de quelques microns à plusieurs dizaines de microns, et jusqu'à quelques centaines de microns.

Comme mentionné ci-dessus, l'étape e) d'amincissement pourra comporter des traitements thermiques pour la finition de la face 5b de la couche utile 5. Le substrat 10 supporte bien les traitements thermiques, même à des températures élevées (900°C à 1100°C, voire 1200°C), notamment parce que la couche composite frittée 2 présente un coefficient de dilatation thermique apparié avec celui du substrat support 1, limitant ainsi les contraintes et déformations associées (courbure) du substrat 10.

L'invention concerne également une structure 100 de dispositifs microélectroniques radiofréquences comprenant :
- un substrat 10 tel que décrit précédemment ;
- et une couche de dispositifs microélectroniques 20, élaborée sur ledit substrat 10 (figure 4), et en particulier sur la face 5b de la couche utile 5.

Le dispositif microélectronique pourra être un commutateur ou adaptateur d'antenne ou un amplificateur de puissance ou un amplificateur faible bruit ou un composant passif ou autre circuit fonctionnant à haute fréquence ou un composant MEMS radiofréquence ou un filtre radiofréquence.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Substrat (10) pour des dispositifs microélectroniques radiofréquences comprenant :
- un substrat support (1),
- une couche intermédiaire (4),
- une couche utile (5) disposée sur la couche intermédiaire (4),
**caractérisé en ce que** le substrat support (1) est en matériau semi-conducteur **et en ce que** le substrat (10) comprend une couche composite frittée (2), disposée sur le substrat support (1) et formée à partir d'un mélange de poudres d'au moins un premier matériau diélectrique et un deuxième matériau diélectrique différent du premier, la nature du premier matériau, la nature du deuxième matériau et la proportion desdits matériaux dans le mélange de poudres étant choisies pour conférer à la couche composite frittée (2) un coefficient de dilatation thermique apparié avec celui du substrat support (1), à plus ou moins 30%, ladite couche composite frittée (2) présentant une épaisseur comprise entre 5 microns et 100 microns, la couche intermédiaire (4) étant disposée sur la couche composite frittée (2).

2. Substrat (10) pour des dispositifs microélectroniques radiofréquences selon la revendication précédente, dans lequel la couche composite frittée (2) présente une épaisseur comprise entre 10 microns et 100 microns.

3. Substrat (10) pour des dispositifs microélectroniques radiofréquences selon l'une des revendications précédentes, dans lequel le substrat support (1) présente une résistivité supérieure à 500 ohm.cm.

4. Substrat (10) pour des dispositifs microélectroniques radiofréquences selon l'une des revendications précédentes, dans lequel le substrat support (1) est en silicium.

5. Substrat (10) pour des dispositifs microélectroniques radiofréquences selon l'une des revendications précédentes, dans lequel les premier et deuxième matériaux diélectriques sont choisis parmi l'oxyde de silicium, le nitrure de silicium, le nitrure d'aluminium, l'alumine, la mullite.

6. Substrat (10) pour des dispositifs microélectroniques radiofréquences selon l'une des revendications précédentes, comprenant une couche de protection (3) disposée entre le substrat support (1) et la couche composite frittée (2).

7. Substrat (10) pour des dispositifs microélectroniques radiofréquences selon l'une des revendications précédentes, dans lequel la couche intermédiaire (4) est une couche diélectrique formée d'un matériau choisi parmi un oxyde de silicium, un nitrure de silicium, un oxynitrure de silicium, un nitrure d'aluminium.

8. Substrat (10) pour des dispositifs microélectroniques radiofréquences selon l'une des revendications précédentes, dans lequel la couche utile (5) est composée d'un matériau choisi parmi les matériaux semi-conducteurs, isolants ou conducteur, ou encore les matériaux piézoélectriques.

9. Structure (100) de dispositifs microélectroniques radiofréquences comprenant :
• un substrat (10) selon la revendication précédente ;
• une couche de dispositifs microélectroniques (20), disposée sur ledit substrat (10).

10. Structure (100) de dispositifs microélectroniques radiofréquences selon la revendication précédente, dans laquelle le dispositif microélectronique (20) est un commutateur ou adaptateur d'antenne ou un amplificateur de puissance ou un amplificateur faible bruit ou un composant passif ou autre circuit fonctionnant à haute fréquence ou un composant MEMS radiofréquence ou un filtre radiofréquence.

11. Procédé de fabrication d'un substrat (10) pour des dispositifs microélectroniques radiofréquences, **caractérisé en ce qu'**il comprend les étapes suivantes :
a) La fourniture d'un substrat support (1) en un matériau semi-conducteur, présentant une première face (1a) ;
b) Le dépôt d'une couche (2') formée d'un mélange de poudres d'au moins un premier matériau diélectrique et un deuxième matériau diélectrique différent du premier, sur la première face (1a) du substrat support (1) ;
c) Le frittage de la couche (2') formée du mélange de poudres pour obtenir une couche composite frittée (2) solidaire de la première face (1a) du substrat support (1) et présentant une épaisseur comprise entre 5 microns et 100 microns ; le premier matériau, le deuxième matériau et la proportion desdits matériaux dans le mélange de poudres étant choisis pour conférer à la couche composite frittée (2) un coefficient de dilatation thermique apparié avec celui du substrat support (1), à plus ou moins 30% ;
d) L'assemblage d'une couche utile (5) et du substrat support (1) de manière à disposer la couche composite frittée (2) entre la couche utile (5) et le substrat support (1), une couche intermédiaire (4) étant disposée entre la couche utile (5) et la couche composite frittée (2) .

12. Procédé de fabrication d'un substrat (10) pour des dispositifs microélectroniques radiofréquences selon la revendication précédente, dans lequel la première face (1a) du substrat support (1) comporte une couche de protection (3), préalablement au dépôt de la couche (2') formée du mélange de poudres de l'étape b).

13. Procédé de fabrication d'un substrat (10) pour des dispositifs microélectroniques radiofréquences selon la revendication précédente, dans lequel la couche de protection (3) est formée par au moins un matériau choisi parmi le nitrure de silicium, l'oxynitrure de silicium, l'oxyde de silicium.

14. Procédé de fabrication d'un substrat (10) pour des dispositifs microélectroniques radiofréquences selon l'une des trois revendications précédentes, dans lequel le mélange de poudres se présente sous la forme d'une pâte visqueuse, et le dépôt de la couche (2') formée par ledit mélange à l'étape b) est réalisé par enduction centrifuge.

15. Procédé de fabrication d'un substrat (10) pour des dispositifs microélectroniques radiofréquences selon la revendication précédente, dans lequel le dépôt de la couche (2') formée par le mélange de poudres est suivi d'un traitement thermique à basse température, pour évacuer au moins un composant liquide de la pâte visqueuse.

16. Procédé de fabrication d'un substrat (10) pour des dispositifs microélectroniques radiofréquences selon l'une des deux revendications précédentes, dans lequel la couche utile (5) fournie pour l'étape d) d'assemblage est un substrat donneur (5') composé d'un matériau choisi parmi les matériaux semi-conducteurs, isolants ou conducteur, ou encore les matériaux piézoélectriques.

17. Procédé de fabrication d'un substrat (10) pour des dispositifs microélectroniques radiofréquences selon la revendication précédente, comprenant une étape e) d'amincissement du substrat donneur (5') jusqu'à l'épaisseur souhaitée de la couche utile (5) pour la fabrication des dispositifs microélectroniques radiofréquences (20).

## Patentansprüche

1. Substrat (10) für mikroelektronische Hochfrequenzvorrichtungen, umfassend:
- ein Trägersubstrat (1),
- eine Zwischenschicht (4),
- eine Nutzschicht (5), die auf der Zwischenschicht (4) angeordnet ist,
**dadurch gekennzeichnet, dass** das Trägersubstrat (1) aus Halbleitermaterial ist **und dass** das Substrat (10) eine gesinterte Verbundschicht (2) umfasst, die auf dem Trägersubstrat (1) angeordnet und aus einer Pulvermischung von mindestens einem ersten dielektrischen Material und einem zweiten dielektrischen Material ausgebildet ist, das sich von dem ersten unterscheidet, wobei die Art des ersten Materials, die Art des zweiten Materials und das Verhältnis der Materialien in der Pulvermischung zum Übertragen eines Wärmeausdehnungskoeffizienten, der mit dem des Trägersubstrats (1) zusammenpasst, von mehr oder weniger 30 % auf die gesinterte Verbundschicht (2) ausgewählt sind, wobei die gesinterte Verbundschicht (2) eine Dicke zwischen 5 Mikrometer und 100 Mikrometer aufweist, wobei die Zwischenschicht (4) auf der gesinterten Verbundschicht (2) angeordnet ist.

2. Substrat (10) für mikroelektronische Hochfrequenzvorrichtungen nach dem vorstehenden Anspruch, wobei die gesinterte Verbundschicht (2) eine Dicke zwischen 10 Mikrometer und 100 Mikrometer aufweist.

3. Substrat (10) für mikroelektronische Hochfrequenzvorrichtungen nach einem der vorstehenden Ansprüche, wobei das Trägersubstrat (1) einen spezifischen Widerstand über 500 ohm.cm aufweist.

4. Substrat (10) für mikroelektronische Hochfrequenzvorrichtungen nach einem der vorstehenden Ansprüche, wobei das erste Trägersubstrat (1) aus Silicium ist.

5. Substrat (10) für mikroelektronische Hochfrequenzvorrichtungen nach einem der vorstehenden Ansprüche, wobei das erste und das zweite dielektrische Material aus Siliciumoxid, Siliciumnitrid, Aluminiumnitrid, Aluminiumoxid, Mullit ausgewählt sind.

6. Substrat (10) für mikroelektronische Hochfrequenzvorrichtungen nach einem der vorstehenden Ansprüche, umfassend eine Schutzschicht (3), die zwischen dem Trägersubstrat (1) und der gesinterten Verbundschicht (2) angeordnet ist.

7. Substrat (10) für mikroelektronische Hochfrequenzvorrichtungen nach einem der vorstehenden Ansprüche, wobei die Zwischenschicht (4) eine dielektrische Schicht ist, die aus einem Material ausgebildet ist, das aus Siliciumoxid, Siliciumnitrid, Siliciumoxynitrid, Aluminiumnitrid ausgewählt ist.

8. Substrat (10) für mikroelektronische Hochfrequenzvorrichtungen nach einem der vorstehenden Ansprüche, wobei die Nutzschicht (5) aus einem Material besteht, das aus Halbleiter-, isolierenden oder leitfähigen Materialien oder sogar piezoelektrischen Materialien ausgewählt ist.

9. Struktur (100) von mikroelektronischen Hochfrequenzvorrichtungen, umfassend:
• ein Substrat (10) nach dem vorstehenden Anspruch;
• eine Schicht von mikroelektronischen Vorrichtungen (20), die auf dem Substrat (10) angeordnet ist.

10. Struktur (100) von mikroelektronischen Hochfrequenzvorrichtungen nach dem vorstehenden Anspruch, wobei die mikroelektronische Vorrichtung (20) ein Antennenumschalter oder -adapter oder ein Leistungsverstärker oder ein rauscharmer Verstärker oder eine passive Komponente oder eine andere Schaltung, die bei hoher Frequenz arbeitet, oder eine Hochfrequenz-MEMS-Komponente oder ein Hochfrequenzfilter ist.

11. Verfahren zum Herstellen eines Substrats (10) für mikroelektronische Hochfrequenzvorrichtungen, **dadurch gekennzeichnet, dass** es die folgenden Schritte umfasst:
a) Bereitstellen eines Trägersubstrats (1) aus einem Halbleitermaterial, das eine erste Fläche (1a) aufweist;
b) Abscheiden einer Schicht (2'), die aus einer Pulvermischung von mindestens einem ersten elektrischen Material und einem zweiten dielektrischen Material ausgebildet ist, das sich von dem ersten unterscheidet, auf die erste Fläche (1a) des Trägersubstrats (1);
c) Sintern der Schicht (2'), die aus der Pulvermischung ausgebildet ist, zum Erhalten einer gesinterten Verbundschicht (2), die mit der ersten Fläche (1a) des Trägersubstrats (1) fest verbunden ist und eine Dicke zwischen 5 Mikrometer und 100 Mikrometer aufweist; wobei das erste Material, das zweite Material und das Verhältnis der Materialien in der Pulvermischung zum Übertragen eines Wärmeausdehnungskoeffizienten, der mit dem des Trägersubstrats (1) zusammenpasst, von mehr oder weniger 30 % auf die gesinterte Verbundschicht (2) ausgewählt sind;
d) Anordnen einer Nutzschicht (5) und eines Trägersubstrats (1) so, um die gesinterte Verbundschicht (2) zwischen der Nutzschicht (5) und dem Trägersubstrat (1) anzuordnen, wobei eine Zwischenschicht (4) zwischen der Nutzschicht (5) und der gesinterten Verbundschicht (2) angeordnet ist.

12. Verfahren zum Herstellen eines Substrats (10) für mikroelektronische Hochfrequenzvorrichtung nach dem vorstehenden Anspruch, wobei die erste Fläche (1a) des Trägersubstrats (1) eine Schutzschicht (3) aufweist, vor dem Abscheiden der Schicht (2'), die aus der Pulvermischung ausgebildet ist, von Schritt b).

13. Verfahren zum Herstellen eines Substrats (10) für mikroelektronische Hochfrequenzvorrichtungen nach dem vorstehenden Anspruch, wobei die Schutzschicht (3) aus mindestens einem Material ausgebildet ist, das aus Siliciumnitrid, Siliciumoxynitrid, Siliciumoxid und Aluminiumoxid ausgewählt ist.

14. Verfahren zum Herstellen eines Substrats (10) für mikroelektronische Hochfrequenzvorrichtungen nach einem der drei vorstehenden Ansprüche, wobei die Pulvermischung in Form einer viskosen Paste vorhanden ist und das Abscheiden der Schicht (2'), die durch die Mischung ausgebildet ist, in Schritt b) durch Schleuderbeschichtung erfolgt.

15. Verfahren zum Herstellen eines Substrats (10) für mikroelektronische Hochfrequenzvorrichtungen nach dem vorstehenden Anspruch, wobei auf das Abscheiden der Schicht (2'), die durch die Pulvermischung ausgebildet ist, eine Wärmebehandlung bei niedriger Temperatur zum Entziehen mindestens einer flüssigen Komponente aus der viskosen Paste folgt.

16. Verfahren zum Herstellen eines Substrats (10) für mikroelektronische Hochfrequenzvorrichtungen nach einem der zwei vorstehenden Ansprüche, wobei die Nutzschicht (5), die für Schritt d) des Anordnens bereitgestellt wird, ein Donorsubstrat (5') ist, das aus Material besteht, das aus Halbleiter-, isolierenden oder leitfähigen Materialien oder sogar piezoelektrischen Materialien ausgewählt ist.

17. Verfahren zum Herstellen eines Substrats (10) für mikroelektronische Hochfrequenzvorrichtungen nach dem vorstehenden Anspruch, umfassend einen Schritt e) eines Verdünnens des Donorsubstrats (5') bis zu der gewünschten Dicke der Nutzschicht (5) für die Herstellung von mikroelektronischen Hochfrequenzvorrichtungen (20).

## Claims

1. Substrate (10) for radio-frequency microelectronic devices, comprising:
- a carrier substrate (1),
- an intermediate layer (4),
- a useful layer (5) arranged on the intermediate layer (4),
**characterized in that** the carrier substrate (1) is made of semiconductor material **and in that** the substrate (10) comprises a sintered composite layer (2) which is arranged on the carrier substrate (1) and is formed from a powder mixture of at least a first dielectric material and a second dielectric material different from the first, the nature of the first material, the nature of the second material, and the proportion of said materials in the powder mixture being selected to provide the sintered composite layer (2) with a thermal expansion coefficient matching that of the carrier substrate (1) within plus or minus 30%, said sintered composite layer (2) having a thickness of between 5 microns and 100 microns, the intermediate layer (4) being arranged on the sintered composite layer (2).

2. Substrate (10) for radio-frequency microelectronic devices according to the preceding claim, wherein the sintered composite layer (2) has a thickness of between 10 microns and 100 microns.

3. Substrate (10) for radio-frequency microelectronic devices according to either of the preceding claims, wherein the resistivity of the carrier substrate (1) is higher than 500 ohm.cm.

4. Substrate (10) for radio-frequency microelectronic devices according to any of the preceding claims, wherein the first carrier substrate (1) is silicon.

5. Substrate (10) for radio-frequency microelectronic devices according to any of the preceding claims, wherein the first and second dielectric materials are selected from silicon oxide, silicon nitride, aluminum nitride, alumina, mullite.

6. Substrate (10) for radio-frequency microelectronic devices according to any of the preceding claims, comprising a protective layer (3) arranged between the carrier substrate (1) and the sintered composite layer (2).

7. Substrate (10) for radio-frequency microelectronic devices according to any of the preceding claims, wherein the intermediate layer (4) is a dielectric layer formed of a material selected from a silicon oxide, a silicon nitride, a silicon oxynitride, an aluminum nitride.

8. Substrate (10) for radio-frequency microelectronic devices according to any of the preceding claims, wherein the useful layer (5) is composed of a material selected from semiconductor, insulating or conductive materials, or even piezoelectric materials.

9. Structure (100) of radio-frequency microelectronic devices comprising:
• a substrate (10) according to the preceding claim;
• a layer of microelectronic devices (20) arranged on said substrate (10).

10. Structure (100) of radio-frequency microelectronic devices according to the preceding claim, wherein the microelectronic device (20) is an antenna switch or adapter or a power amplifier or a low noise amplifier or a passive component or other circuit operating at high frequency or an MEMS radio-frequency component or a radio-frequency filter.

11. Method for producing a substrate (10) for radio-frequency microelectronic devices, **characterized in that it** comprises the following steps:
a) providing a carrier substrate (1) made of a semiconductor material having a first surface (1a);
b) depositing a layer (2'), which is formed of a powder mixture of at least a first dielectric material and a second dielectric material different from the first, on the first surface (1a) of the carrier substrate (1);
c) sintering the layer (2') formed of the powder mixture to obtain a sintered composite layer (2) secured to the first surface (1a) of the carrier substrate (1) and having a thickness of between 5 microns and 100 microns; the first material, the second material and the proportion of said materials in the powder mixture being selected to provide the sintered composite layer (2) with a thermal expansion coefficient matching that of the carrier substrate (1) within more or less 30%;
d) assembling a useful layer (5) and the carrier substrate (1) so as to arrange the sintered composite layer (2) between the useful layer (5) and the carrier substrate (1), an intermediate layer (4) being arranged between the useful layer (5) and the sintered composite layer (2).

12. Method for producing a substrate (10) for radio-frequency microelectronic devices according to the preceding claim, wherein the first surface (1a) of the carrier substrate (1) comprises a protective layer (3), prior to the deposition of the layer (2') formed of the powder mixture from step b).

13. Method for producing a substrate (10) for radio-frequency microelectronic devices according to the preceding claim, wherein the protective layer (3) is formed by at least one material selected from silicon nitride, silicon oxynitride, silicon oxide.

14. Method for producing a substrate (10) for radio-frequency microelectronic devices according to any of the three preceding claims, wherein the powder mixture is in the form of a viscous paste, and the deposition of the layer (2') formed by said mixture in step b) is carried out by spin coating.

15. Method for producing a substrate (10) for radio-frequency microelectronic devices according to the preceding claim, wherein the deposition of the layer (2') formed by the powder mixture is followed by a low-temperature heat treatment to remove at least one liquid component from the viscous paste.

16. Method for producing a substrate (10) for radio-frequency microelectronic devices according to one of the two preceding claims, wherein the useful layer (5) provided for the assembly step d) is a donor substrate (5') composed of a material selected from semiconductor, insulating or conductive materials, or even piezoelectric materials.

17. Method for producing a substrate (10) for radio-frequency microelectronic devices according to the preceding claim, comprising a step e) of thinning the donor substrate (5') to the desired thickness of the useful layer (5) for the production of radio-frequency microelectronic devices (20).
